# EUROPÄISCHE PATENTSCHRIFT

(11) **EP 0 848 500 B1**
(45) Veröffentlichungstag und Bekanntmachung des Hinweises auf die Patenterteilung: **29.05.2002**
(21) Anmeldenummer: 97120489.6
(22) Anmeldetag: 21.11.1997
(51) Int. Cl.: H03M 9/00

(54) **Parallel/Seriell-Wandler**
Parallel-serial converter
Convertisseur parallèle-série

(30) Priorität: 13.12.1996 DE 19652003
(43) Veröffentlichungstag der Anmeldung: 17.06.1998
(73) Patentinhaber: Infineon Technologies AG, 81669 München (DE)
(72) Erfinder: Weder, Uwe, Dr., 84072 Au/Hallartau (DE)
(74) Vertreter: Reinhard - Skuhra - Weise & Partner

(56) Entgegenhaltungen:
- EP-A- 0 576 150
- DE-C- 4 430 631
- US-A- 5 197 070
- US-A- 5 349 653

## Beschreibung

Die rasante Entwicklung der Halbleitertechnik ist gekennzeichnet durch permanent steigende Taktraten bei gleichzeitiger Vergrößerung der Chipfläche, der Gatterzahl und der Verlustleistung. Damit ergibt sich bei hochparallelen Bussystemen die Aufgabe, trotz größerer Leitungslängen Signale sehr schnell und verlustleistungsarm zu übertragen. In Bussystemen werden die Informationen auf hochparallelen Busleitungen in Form von Spannungs- oder Strompegeln detektiert und bewertet.

Bei der Spannungsbewertung werden Pegel oftmals mit vollem Versorgungsspannungshub übertragen. Eine Verlustleistungsreduzierung kann durch eine Pegelabsenkung erreicht werden, was allerdings die Übertragungsgeschwindigkeit reduziert. Bei sehr langen Leitungen wird die Spannungsübertragung bezüglich der Leistungsverbrauch und Geschwindigkeit zunehmend problematisch. Lange Leitungen mit Pegeländerungen in der Größenordnung der Versorgungsspannung verursachen außerdem sehr große Probleme hinsichtlich Leitungsübersprechen. Abgewandelte Formen der Spannungsbewertung reduzieren zwar den Spannungshub und zeichnen sich durch eine geringe Verlustleistung aus, sind aber sehr empfindlich gegenüber kapazitiven Einkopplungen.

Bei der Strombewertung wird ein Strom übertragen und es tritt nur ein minimaler Spannungshub auf, der im Idealfall gegen Null geht, wodurch das Leitungsübersprechen drastisch reduziert wird. Speziell bei sehr langen Leitungen ist dieses Prinzip auch bezüglich der Verlustleistung und Geschwindigkeit der Spannungsbewertung überlegen.

Aus der deutschen Patentschrift DE 44 30 631 C1 ist eine Schaltungsanordnung zur Leistungsreduzierung in integrierten Schaltkreisen bekannt, bei der eine Busleitung mit einer Strombewertungsschaltung vorgesehen ist.

Die der Erfindung zugrundeliegende Aufgabe besteht nun darin, einen Parallel/Seriell-Wandler nach dem Strombewertungsprinzip anzugeben, der neben einem geringem Leitungsübersprechen der Bitleitungen und einer geringen Chipfläche zusätzlich vor allem eine hohe Signalverarbeitungsgeschwindigkeit und eine geringe Verlustleistung aufweist und der hinsichtlich Technologieparametern, Temperatur und Versorgungsspannung adaptiv ist, das heißt, daß diese Größen nahezu keinen Einfluß auf die Funktionsfähigkeit des Parallel/Seriell-Wandlers haben.

Diese Aufgabe wird erfindungsgemäß durch die im Anspruch 1 angegebenen Merkmale gelöst. Vorteilhafte Weiterbildungen der Erfindung ergeben sich aus den Unteransprüchen.

Die Erfindung wird nachfolgend anhand der Zeichnungen näher erläutert. Dabei zeigt
- Figur 1: einen erfindungsgemäßen Parallel/Seriell-Wandler,
- Figur 2: eine Detailschaltung eines Pegelgenerators des Wandlers von Figur 1,
- Figur 3: eine Detailschaltung eines Schaltungsteils des Wandlers von Figur 1 und
- Figur 4: ein Zeitdiagramm zur Erläuterung der Funktionsweise der Anordnungen von Figur 1, 2 und 3.

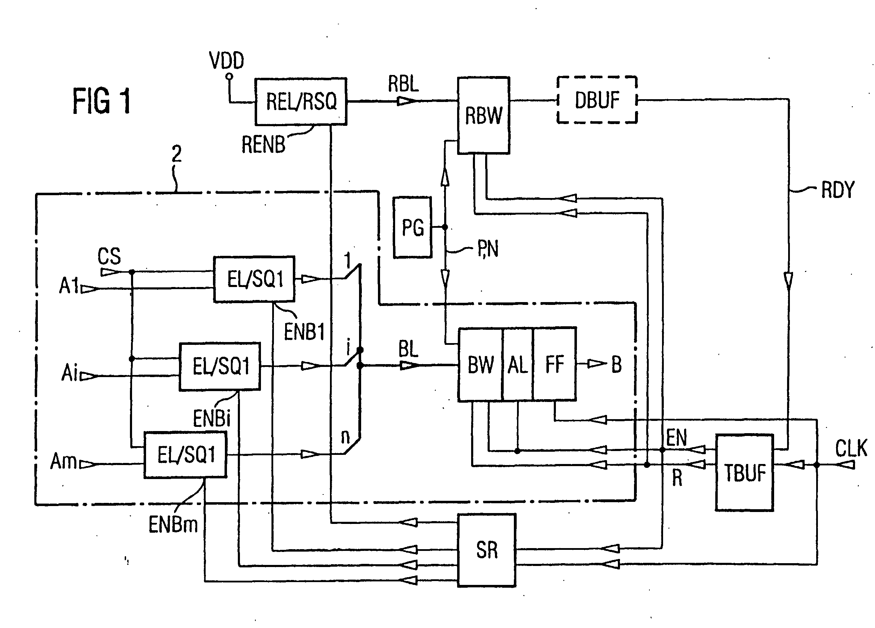

In Figur 1 ist ein erfindungsgemäßer Parallel/Seriell-Wandler dargestellt, der beispielhaft einen einzelnen Signalpfad mit einem Parallel/Seriell-Wandler 2 nach dem Strombewertungsprinzip sowie darüber hinaus einen Referenzpfad aufweist, der über eine Einheit TBUF zur Erzeugung von Steuersignalen und eine Auswahleinrichtung SR den beispielhaft angegebenen Signalpfad bzw. mehrere Signalpfade steuert. In Figur 1 ist lediglich eine einzelne Busleitung BL stellvertretend für normalerweise eine Vielzahl von Busleitungen dargestellt.

Der Referenzpfad weist ein als Stromquelle ausgeführtes Eingangshalteglied REL/RSQ, eine Referenzbusleitung RBL und eine Referenzbewertungseinrichtung RBW sowie gegebenenfalls eine Verzögerungsschaltung DBUF auf. Die Einheit TBUF bildet abhängig von einem Fertigmeldungssignal RDY und einem Taktsignal CLK ein Aktivierungssignal EN und ein Rücksetzsignal R. Die Auswahleinrichtung SR ist beispielsweise in Form eines Schieberegisters realisiert, das durch das Taktsignal CLK getaktet und eingangsseitig mit dem Aktivierungssignal EN aktiviert wird.

Der eigentliche Parallel/Seriell-Wandler 2 des Signalpfades weist als Stromquellen ausgeführte Eingangshalteglieder EL/SQ1 ... EL/SQi ... EL/SQm auf, wobei jeweils ein solches Halteglied mit einem jeweiligen parallelen Eingang A1 ... Ai ... Am und die Ausgänge der Halteglieder mit einer 1 Bit breiten Busleitung BL verbunden sind. Die Halteglieder EL/SQ1 ... EL/SQi ... EL/SQm weisen Aktivierungseingänge ENB1 ... ENBi ... ENBm auf, die über Ausgänge der Auswahleinrichtung SR ansteuerbar sind, wobei eine Aktivierung hier durch den Low-Zustand erfolgt. Die Busleitung BL ist endseitig mit einer Bewertungseinrichtung BW verbunden, die von Ausgangssignalen EN und R eines Pegelgenerator PG angesteuert ist. Der Bewertungseinrichtung BW ist ein Ausgangshalteglied AL und diesem wiederum ein Flip-Flop FF zur Taktsynchronisierung nachgeschaltet, wobei am Ausgang des Flip-Flops FF ein serielles Ausgangssignal B ansteht. Die Bewertungseinrichtung BW ist durch das Signal EN aktivierbar und durch das Signal R rücksetzbar. Die Ausgangshaltestufe ist ebenfalls durch das Signal EN aktivierbar und das Flip-Flop FF wird durch das Taktsignal CLK getaktet.

Das Referenzeingangshalteglied REL/RSQ weist einen Aktivierungseingang RENB auf, der durch die Auswahleinrichtung SR immer dann aktiviert wird, wenn eines der Eingangshalteglieder EL/SQ1 ... EL/SQi ... EL/SQm aktiviert wird. Die Referenzbewertungseinheit RBW ist wie die Bewertungseinheit BW aufgebaut, ist ebenso mit dem Pegelgenerator PG verbunden und erhält ebenfalls das Aktivierungssignal EN und das Rücksetzsignal R.

Das Ausgangssignal der Referenzbewertungseinheit RBW wird entweder direkt oder über eine Zeitverzögerungseinheit DBUF mit einem Eingang der Einheit TBUF verbunden und führt das Fertigmeldungssignal RDY. Die Verzögerungseinheit DBUF verzögert um mehrere Gatterlaufzeiten und dient zur Erhöhung der Datensicherheit.

Die Referenzbusleitung RBL muß eine etwas längere Signallaufzeit aufweisen als die Busleitung BL des Signalpfades. Dies kann zum Beispiel dadurch bewirkt werden, daß die Referenzbusleitung länger ist als jede der. Busleitungen BL oder daß beispielsweise beidseitig neben der Referenzbusleitung RBL im Layout mit Masse verbundene Dummyleitungen plaziert werden, deren Abstand zur Referenzleitung kleiner ist als der zwischen zwei benachbarten Bitleitungen.

Vorteilhafterweise können die Referenzbusleitung RBL und alle Busleitungen BL bei einem Dreimetallagenprozeß in einer höchsten Metallebene geführt werden, die vergleichsweise den geringsten parasitären Kapazitätswert aufweist und in der Regel am niederohmigsten prozessiert wird. Aüßerdem können Busleitungen in der höchsten Metallebene vor Ladungseinstreuungen durch zwangsläufig kreuzende und vollen Spannungspegel führende Leitungen geschützt werden. Dies erfolgt, indem diese kreuzenden Leitungen in einer ersten Metallage geführt werden, bei gleichzeitiger Abschirmung durch überlappende, mit der Versorgungsspannung VDD kontaktierte Leitungen in einer zweiten darüberliegenden Metallebene.

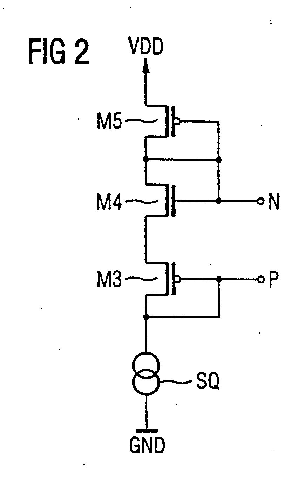

In Figur 2 ist beispielhaft ein Pegelgenerator PG dargestellt, der eine Stromquelle SQ, einen p-Kanal-MOS-Transistor M3, einen n-Kanal-Transistor M4 und einen p-Kanal-Transistor M5 aufweist, wobei die Stromquelle SQ einseitig mit Massepotential GND und über der Reihe nach in Reihe geschaltete Transistoren M3, M4 und M5 mit der Versorgungsspannung VDD verbunden ist und wobei die Gates der Transistoren M4 und M5 mit dem Verbindungspunkt zwischen den beiden Transistoren M4 und M5 über einen Ausgangsknoten N und das Gate des Transistors M3 mit dem Verbindungspunkt zwischen dem Transistor M3 und der Stromquelle SQ über einen Ausgangsknoten P verbunden sind.

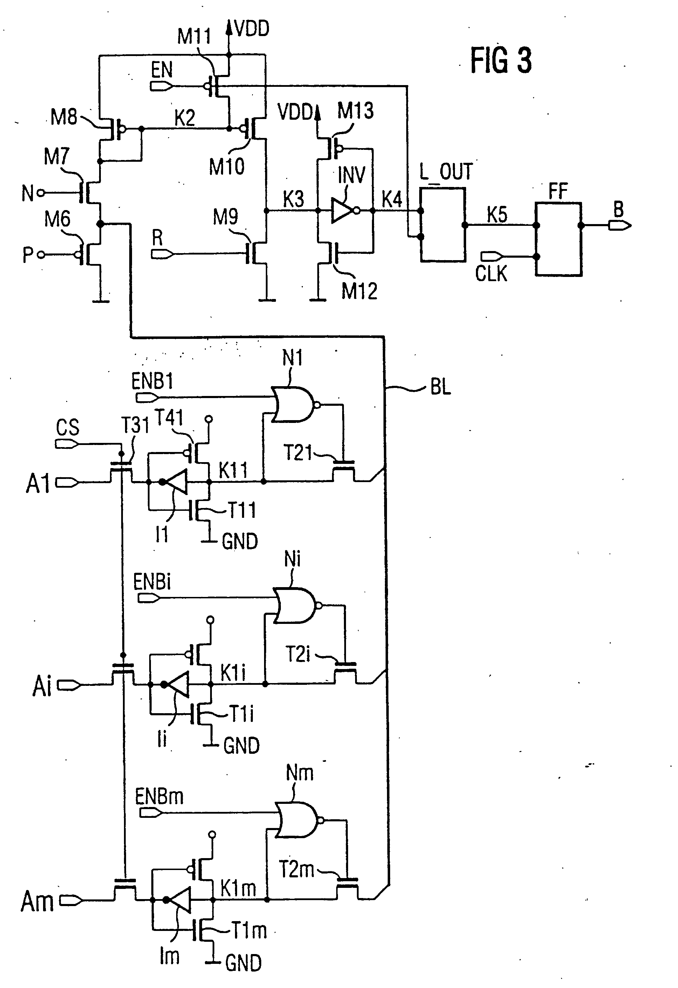

In Figur 3 ist der eigentliche Parallel/Seriell-Wandler 2 mit einer 1 Bit breiten Busleitung BL beispielhaft etwas detaillierter dargestellt. Das als Stromquelle ausgebildete Eingangshalteglied EL/SQ1 enthält dabei ein NAND-Gatter N1, einen Inverter I1 und Transistoren T11 ... T41, wobei die Transistoren T11 und T41 einen Inverter bilden, der einen Ausgangsknoten K11 aufweist und durch einen Inverter I1 rückgekoppelt ist. Der parallele Eingang A1 ist dabei abhängig von einem Auswahlsignal CS über den Transfertransistor T31 mit einem Eingang des aus den Transistoren T41 und T11 gebildeten Inverters verbindbar. Der Ausgangsknoten K11 ist über einen weiteren Transfertransistor T21 mit der Busleitung BL verbindbar, wobei der Ausgang des NAND-Gatters N1 mit dem Gate des Transfertransistors T21 verbunden ist und wobei ein erster Eingang des NAND-Gatters N1 mit dem Aktivierungseingang EN1 und ein zweiter Eingang des NAND-Gatters mit dem Knoten K11 verbunden ist. Die Rückkopplung durch den Inverter I1 bildet dabei zusammen mit dem aus den Transistoren T41 und T11 gebildeten Inverter ein Halteglied, das ausgangsseitig abhängig vom Aktivierungssignal ENB1 über das NAND-Gatter N1 und den Transfertransistor T21 mit der Busleitung BL verbindbar ist. Die weiteren als Stromquelle ausgebildeten Eingangshalteglieder EL/SQ2 ...EL/SQi ...EL/SQm sind entsprechend wie das Eingangshalteglied EL/SQ1 aufgebaut.

Die in Figur 3 dargestellte Bewertungseinrichtung BW weist einen p-Kanal-MOS-Transistor M6, einen n-Kanal-Transistor M7, einen p-Kanal-MOS-Transistor M8, einen n-Kanal-MOS-Transistor M9, einen p-Kanal-Transistor M10 und einen p-Kanal-Transistor M11 auf, wobei die Transistoren M6, M7 und M8 der Reihe nach zwischen Massepotential und Versorgungsspannung VDD geschaltet sind, wobei das Gate des Transistors M7 mit dem Ausgangsknoten N des Pegelgenerators PG und das Gate des Transistors M6 mit dem Ausgangsknoten P des Pegelgenerators PG verbunden sind. Die beiden Transistoren M3 und M6 sowie M4 und M7 sind als Stromspiegel geschaltet, so daß durch die Transistoren M6 und M7 derselbe Strom fließt wie in den Transistoren M3 und M4, nämlich der durch die Stromquelle SQ1 eingeprägte Strom. Die Transistoren M3 ... M8 arbeiten im sogenannten strong inversion-Bereich und es fließt somit ein kleiner permanenter Querstrom. Das Gate des Transistors M8 und das Gate des Transistors M10 ist über einen Knoten K2 mit dem Verbindungspunkt zwischen den beiden Transistoren M7 und M8 sowie über den Transistor M11 mit der Versorgungsspannung VDD verbunden. Ein Anschluß des Transistors M10 ist mit der Versorgungsspannung VDD und der zweite Anschluß des Transistors M10 über den Knotenpunkt K3 mit einem ersten Anschluß des Transistors M9 verbunden, dessen zweiter Anschluß mit Massepotential beschaltet ist. Das Gate des Transistors M11 wird durch das Aktivierungssignal EN und das Gate des Transistors M9 durch das Resetsignal R angesteuert. Der Knoten K3 ist über einen Inverter INV mit einem Knoten K4 verbunden. Da der Inverter INV über einen aus einem n-Kanal-MOS-Transistor M12 und einem p-Kanal-MOS-Transistor M13 aufgebauten schwachen Inverter rückgekoppelt ist, wobei der schwache Inverter in seiner Stromergiebigkeit schwächer ausgelegt ist als der Inverter INV, geht letzterer am Ausgang erst ab einer definierten von Null verschiedenen Eingangsstromstärkeschwelle in einen anderen Zustand über. Der Knoten K4 ist mit dem Eingang der Ausgangshaltestufe L_OUT verbunden und kann abhängig vom Aktivierungssignal EN auf einen Knoten K5 durchgeschaltet werden. Der Knoten K5 ist hier mit einem Eingang des Flip-Flops FF beschaltet, wobei das Flip-Flop durch das Taktsignal CLK getaktet wird und am Ausgang das serielle Ausgangssignal B liefert.

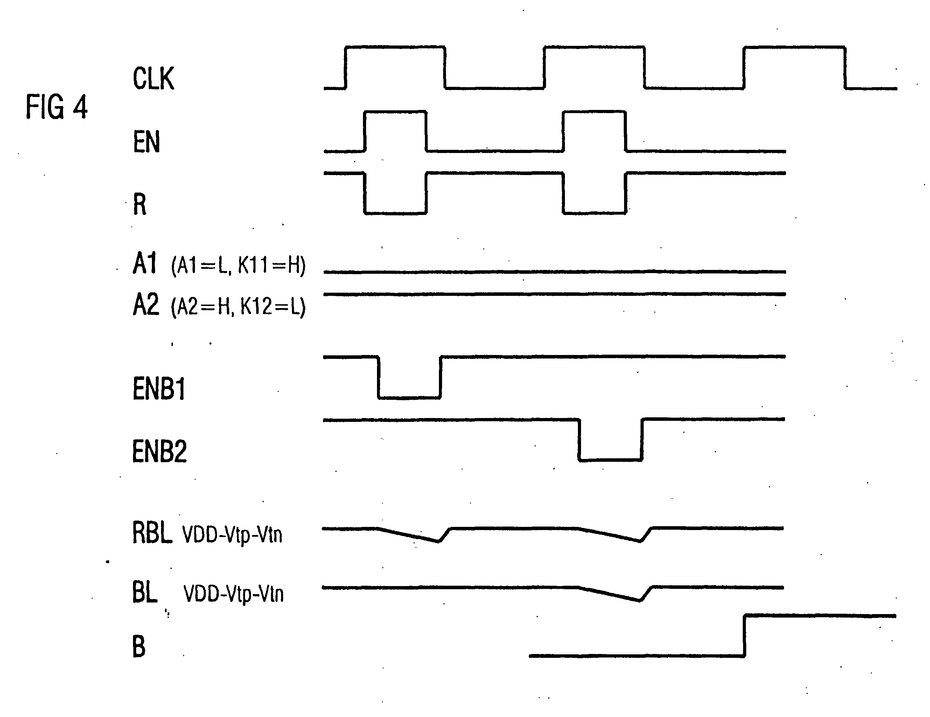

In Figur 4 sind das Taktsignal CLK mit einem Tastverhältnis von 1:1, das Aktivierungssignal EN, das Rücksetzsignal R, Eingangssignale A1 und A2, Aktivierungssignale ENB1 und ENB2, das Referenzbusleitungssignal RBL, das Busleitungssignal BL und das serielle Ausgangssignal B zeitlich korreliert dargestellt. Der parallele Eingang A1 hat Low-Potential, wodurch der Knoten K11 High-Potential hat und der parallele Eingang A2 weist High-Potential auf, wodurch der Knoten K12 auf Low-Potential liegt. Zuerst wird durch das Aktivierungssignal ENB1 das erste Eingangshalteglied und durch das Aktivierungssignal RENB das Referenzeingangshalteglied aktiviert. Auf der Referenzbusleitung zeigt sich ein kleiner Spannungseinbruch, auf der Signalbusleitung BL jedoch nicht, da die Busleitung BL aufgrund von A1 keinen Strom führt. Anschließend wird das zweite Eingangshalteglied durch das Aktivierungssignal ENB2 und durch das Aktivierungssignal RENB das Referenzeingangshalteglied aktiviert. Sowohl die Referenzbusleitung RBL als auch die Signalbusleitung BL weisen nun einen kleinen Spannungseinbruch auf, da der Eingang A2 High-Potential aufweist und über die Busleitung BL und die Transistoren T22 und T12 ein Strom gegen Massepotential GND fließt. Mit dem nächsten Taktimpuls liegt das zweite Eingangssignal als serielles Ausgangssignal B an und so weiter.

Zu Beginn einer Bewertungsphase sind die Transistoren M9 und M11 gesperrt, der Knoten K3 liegt auf Low-Potential und der Knoten K4 auf High-Potential. Das Ausgangshalteglied L_OUT ist auf Durchgang geschaltet, wodurch das Signal des Knotens 4 invertiert auf den Knoten K5 geschaltet wird, also der Knoten K5 auf Low-Potential liegt. Die Busleitung wird mit Hilfe der Pegelgeneratorschaltung PG auf einem Potential von näherungsweise VDD - Vtp - Vtn gehalten, wobei die Spannung Vtp die Schwellenspannung des p-Kanal-MOS-Transistors M5 und die Spannung Vtn die Schwellenspannung des n-Kanal-Transistors M4 darstellt. Entsprechend dem Potential am Knoten K1i mit den Transistoren T1i, T2i wird ein Strom eingeprägt oder nicht eingeprägt. Mit diesem Prinzip wird eine dynamische Verdopplung des kapazitiven Übersprechens durch gegenläufig angesteuerte Busleitungen vermieden.

Weiterhin können die Stromquellentransistoren T1i, T2i im Gegensatz zu den bei der Spannungsbewertung erforderlichen starken Treibern näherungsweise als Minimaltransistoren ausgelegt werden, was aufgrund der Vielzahl dieser Elemente die Chipfläche drastisch reduziert. Für den Fall K1i = H wird kein Strom eingeprägt, die Bewertungseinrichtung verbleibt im Initialzustand. Für den Fall K1i = L wird der eingeprägte Strom über den Transistor M8 zum Transistor M10 gespiegelt und bewirkt ein Kippen des rückgekoppelten Inverters INV. Im Gegensatz zu der in der Patentschrift DE 44 30 631 C1 angegebenen Schaltungsanordnung liegt der Arbeitspunkt der Busleitung um die Schwellenspannung Vtp tiefer, wodurch der Innenwiderstand der Bewertungseinrichtung und dadurch die Spannungsänderung auf der Busleitung wesentlich reduziert werden. Noch entscheidender ist die fast vollständige Übernahme des eingeprägten Stromes durch den Transistor M8, gerade zu Beginn der Bewertungsphase, wodurch die Reaktionszeit am Knoten K2 drastisch reduziert wird. Nach dem Rücksetzen durch das Rücksetzsignal R ist der Knoten K3 mit Low-Potential und der Knoten K4 mit High-Potential initialisiert. Der Spiegeltransistor M10 übertreibt nun den schwachen n-Kanal-Rückkoppeltransistor M12, was dazu führt, daß der Knoten K3 High-Potential und damit der Knoten K4 Low-Potential annimmt.

Zur Beschleunigung der weiteren Signalverarbeitung wird vorteilhafterweise ein Ausgangshalteglied L_OUT mit einem n-Kanal-MOS-Transistor als Transfertransistor am Eingang (n-Kanal-Latch) gewählt, das während der zeitkritischen Bewertungsphase das dann möglicherweise am Knoten K4 anliegende Low-Potential mit nur sehr geringer Verzögerung weiterleitet. Der Transfertransistor ist dabei ähnlich wie z. B. der Transsistor T31 in Figur 3, der zwischen dem Eingang A1 und dem Inverter I1 des Eingangshalteglieds liegt.

Das Beenden aller Strombewertungsvorgänge mit den Steuersignalen R und EN erfolgt dabei über die gemeinsame Referenzbewertereinheit RBW, die identisch zu den anderen Bewertereinheiten BW aufgebaut ist. Das Beenden darf auch unter Berücksichtigung differierender Laufzeiten auf den Busleitungen erst dann erfolgen, wenn die Information am Knoten K5 jeweils stabil ist.

Sobald das Aktivierungssignal EN Low-Potential annimmt, wird die am Knoten K4 anstehende Information in das Ausgangshalteglied L_OUT übernommen. Außerdem wird der Knoten K2 näherungsweise auf die Versorgungsspannung VDD gezogen. Mit dem Resetsignal R = High wird die erneute Initialisierung, ausgehend vom Knoten K3 = Low gestartet. Wesentlich ist, daß die Busleitung in kürzester Zeit wieder exakt auf die Initialspannung gebracht wird. Dies ist bei der Schaltungsanordnung der Patentschrift DE 44 30 631 C1 nicht möglich, da deren entsprechende Transistoren im sogenannten weak inversion-Bereich arbeiten und zudem von selbst nur sehr langsam in den Sperrzustand übergehen. Eine drastische Beschleunigung des Rücksetzvorganges wird durch den Transistor M11 und einen kleinen permanenten Querstrom durch die im sogenannten strong inversion-Bereich arbeitenden Transistoren M6 ... M8 erreicht. Mit dem High-Low-Übergang des Aktivierungssignal EN wird schließlich über das jeweils aktuelle Aktivierungssignal ENBi und den Transistor T2i das jeweilige als Stromquelle ausgebildete Halteglied EL/Sqi abgeschaltet.

Die Bewertungs- und Rücksetzphase lassen aufgrund der beschriebenen Maßnahmen sehr hohe Taktfrequenzen zu. Außerdem ist im Gegensatz zu der in Patentschrift DE 44 030 631 C1 beschriebenen Schaltungsanordnung die Bewertungsphase nicht auf die halbe Periodendauer T/2 begrenzt, was wiederum die Vorgabe noch höherer Taktfrequenzen zuläßt. Die Stromquellentransistoren T1i und T2i liefern den wesentlichen Beitrag zum Verlustleistungsverbrauch der Gesamtschaltung. Das adaptive Beenden der Bewertungsphase hinsichtlich der Versorgungsspannung, Temperatur und Technologieparametern führt auch auf ein adaptives Abschalten der Stromquellentransistoren T1i und T2i. Die Unabhängigkeit der Stromquellenzuschaltung von der Frequenz des Taktsignals CLK ergibt schließlich auch eine wesentliche Reduzierung der Gesamtleistungsaufnahme.

Nicht zuletzt wegen der zunehmend gebräuchlichen großen Chipkantenlängen von beispielsweise bis zu 15 mm, werden Busleitungen BL bzw. Referenzbusleitung RBL beispielsweise mit einer Länge von mehr als 6 mm benötigt.

Bei einem realisierten integrierten Schaltkreis sind beispielsweise 288 Busleitungen mit je 16, also mit insgesamt 4608, als Stromquellen ausgebildeten Eingangshaltegliedern EL/SQ vorgesehen. Der maximaleSpannungshub auf den Busleitungen beträgt dabei lediglich ca. 0,25 Volt. Der realisierte integrierte Schaltkreis enthält einen Pegelgenerator PG, fünf Referenzpfade mit den Einheiten REL/RSQ, RBL, RBW und gegebenenfalls DBUF sowie fünfmal die Einheiten TBUF und SR. Diese integrierte Schaltung wird mit einem Taktsignal betrieben, das eine Periodendauer von T = 9,8 ns aufweist.

## Patentansprüche

1. Parallel/Seriell-Wandler,
- bei dem als Stromquellen ausgebildete Eingangshalteglieder (EL/SQ1 ... EL/SQi ... EL/SQm) jeweils eingangsseitig mit parallelen Eingängen (A1 ... Ai ... Am) und ausgangsseitig mit einer Signalbusleitung (BL) verbunden sind, wobei die Eingangshalteglieder einzeln durch eine mit einem Taktsignal (CLK) getaktete Auswahleinrichtung (SR) aktivierbar sind,
- bei dem eine Bewertungseinheit (BW) vorgesehen ist, die eingangsseitig mit der Signalbusleitung (BL) verbunden ist und aus deren Ausgangssignal (K4) über Ausgangshalteglied (L_OUT) ein serielles Ausgangssignal (B) gebildet ist,
- bei dem ein als Stromquelle ausgebildetes Referenzeingangshalteglied (REL/RSQ) vorgesehen ist, das jedesmal gleichzeitig mit einem der Eingangshalteglieder aktiviert wird und das ausgangsseitig über eine Referenzbusleitung (RBL) mit einer Referenzbewertungseinheit (RBW) verbunden ist, wobei die Referenzbusleitung stets eine größere Signallaufzeit aufweist als die Laufzeit der Signalbusleitung (BL), und
- bei dem aus dem Ausgangssignal der Referenzbewertereinheit ein Fertigmeldesignal (RDY) erzeugt und in einer Einheit (TBUF) aus diesem zusammen mit dem Taktsignal (CLK) ein Aktivierungssignal (EN) gebildet ist, das dem Ausgangshalteglied (L_OUT) als Übernahmesignal zugeführt ist.

2. Parallel/Seriell-Wandler nach Anspruch 1,
bei dem der Auswahleinheit (SR) das Aktivierungssignal (EN) zugeführt ist und die als Stromquelle ausgebildeten Eingangshalteglieder in Abhängigkeit des Aktivierungssignal (EN) ausgangsseitig angeschaltet/abgeschaltet werden, wobei eine Bewertungsphase auch länger als die halbe Periodendauer des Taktsignals (CLK) dauert.

3. Parallel/Seriell-Wandler nach einem der Ansprüche 1 oder 2, bei dem in der Bewertungseinrichtung (BW) zwischen der Bitleitung (BL) und Massepotential (GND) und der Bitleitung und Versorgungsspannung (VDD) vorgesehene Transistoren (M6 ... M8) so angesteuert sind, daß sie im strong inversion-Bereich arbeiten und ein permanenter Querstrom durch diese Transistoren fließt.

4. Parallel/Seriell-Wandler nach einem der Ansprüche 1 bis 3, bei dem die Busleitung (BL) mit Hilfe eines Pegelgenerators (PG) auf einem Potential von näherungsweise der Versorgungsspannung (VDD) vermindert um die Schwellenspannung (Vtp) eines p-Kanal-Transistors und vermindert um die Schwellenspannung (Vtn) eines n-Kanal-Transistors gehalten wird.

5. Parallel/Seriell-Wandler nach einem der Ansprüche 1 bis 4, bei dem die Bewertungseinheit (BW) und die Referenzbewertungseinheit (RBW) einen zusätzlichen Transistor (M11) zwischen dem Gate eines mit der Versorgungsspannung verbundenen n-Kanal-MOS-Transistors und der Versorgungsspannung aufweisen, der durch das Aktivierungssignal (EN) angesteuert wird.

6. Parallel/Seriell-Wandler nach einem der Ansprüche 1 oder 5, bei dem die Signallaufzeit der Referenzbusleitung (RBL) dadurch größer ist als die Signallaufzeit der Signalbusleitung (BL), daß die Länge der Referenzbusleitung größer ist als die Länge der Signalbusleitung und/oder daß neben der Referenzbusleitung zusätzlich zwei Massepotential führende und zusätzlich Leitungskapazität verursachende Leitungen vorgesehen sind.

7. Parallel/Seriell-Wandler nach einem der vorhergehenden Ansprüche, bei dem der Referenzbewertungseinheit zusätzlich eine Verzögerungsstufe (DBUF) nachgeschaltet ist.

## Claims

1. Parallel/serial converter,
- in which input holding elements (EL/SQ1 ... EL/SQi .. EL/SQm) designed as current sources are in each case connected to parallel inputs (A1 ... Ai ... Am) on the input side and to a signal bus line (BL) on the output side, the input holding elements being able to be individually activated by a selection device (SR), which is clocked with a clock signal (CLK),
- in which an evaluation unit (BW) is provided, which is connected to the signal bus line (BL) on the input side and from whose output signal (K4), via output holding element (L_OUT), a serial output signal (B) is formed,
- in which a reference input holding element (REL/RSQ) designed as a current source is provided, which is activated each time simultaneously with one of the input holding elements and is connected, on the output side, to a reference evaluation unit (RBW) via a reference bus line (RBL), the reference bus line always having a longer signal propagation time than the propagation time of the signal bus line (BL), and
- in which a ready indication signal (RDY) is generated from the output signal of the reference evaluation unit and, in a unit (TBUF), an activation signal (EN) is formed from the said ready indication signal together with the clock signal (CLK), which activation signal is fed to the output holding element (L_OUT) as acceptance signal.

2. Parallel/serial converter according to Claim 1, in which the activation signal (EN) is fed to the selection unit (SR) and the input holding elements designed as current source are switched on/switched off on the output side in a manner dependent on the activation signal (EN), an evaluation phase also lasting longer than half the period duration of the clock signal (CLK).

3. Parallel/serial converter according to either of Claims 1 and 2, in which transistors (M6 ... M8) provided in the evaluation device (BW) between the bit line (BL) and earth potential (GND) and the bit line and supply voltage (VDD) are driven in such a way that they operate in the strong inversion region and a permanent shunt current flows through these transistors.

4. Parallel/serial converter according to one of Claims 1 to 3, in which the bus line (BL), with the aid of a level generator (PG), is held at a potential of approximately the supply voltage (VDD) reduced by the threshold voltage (Vtp) of a p-channel transistor and reduced by the threshold voltage (Vtn) of an n-channel transistor.

5. Parallel/serial converter according to one of Claims 1 to 4, in which the evaluation unit (BW) and the reference evaluation unit (RBW) have an additional transistor (M11) between the gate of an n-channel MOS transistor, connected to the supply voltage, and the supply voltage, which is driven by the activation signal (EN).

6. Parallel/serial converter according to either of Claims 1 and 5, in which the signal propagation time of the reference bus line (RBL) is longer than the signal propagation time of the signal bus line (BL) by the length of the reference bus line being longer than the length of the signal bus line and/or by two lines which carry earth potential and additionally cause line capacitance additionally being provided beside the reference bus line.

7. Parallel/serial converter according to one of the preceding claims, in which a delay stage (DBUF) is additionally connected downstream of the reference evaluation unit.

## Revendications

1. Convertisseur parallèle/ série,
- dans lequel des éléments de maintien d'entrée (EL/SQ1 ... EL/SQi ... EL/SQm), réalisés comme des sources de courant, sont reliés respectivement en entrée à des entrées parallèles (A1 ... Ai ... Am) et en sortie à une ligne de bus de signal (BL), les éléments de maintien d'entrée pouvant être activés individuellement par un dispositif de sélection (SR) cadencé par un signal d'horloge (CLK),
- dans lequel une unité d'évaluation (BW) est prévue qui est reliée en entrée à la ligne de bus de signal (BL) et à partir du signal de sortie (K4) de laquelle, un signal de sortie série (B) est formé par l'intermédiaire de l'élément de maintien de sortie (L_OUT),
- dans lequel un élément de maintien d'entrée de référence (REL/RSQ), réalisé comme une source de courant, est prévu qui est activé à chaque fois en même temps qu'un des éléments de maintien d'entrée et qui est relié en sortie par l'intermédiaire d'une ligne de bus de référence (RBL) à une unité d'évaluation de référence (RBW), la ligne de bus de référence présentant toujours un temps de propagation de signal supérieur au temps de propagation de la ligne de bus de signal (BL), et
- dans lequel un signal d'avertissement d'état prêt (RDY) est généré à partir du signal de sortie de l'unité d'évaluation de référence, et dans une unité (TBUF), à partir dudit signal en combinaison avec le signal d'horloge (CLK), un signal d'activation (EN) est formé qui est amené à l'élément de maintien de sortie (L_OUT) comme signal de prise en charge.

2. Convertisseur parallèle/ série selon la revendication 1, dans lequel le signal d'activation (EN) est amené à l'unité de sélection (SR) et les éléments de maintien d'entrée réalisés comme une source de courant sont mis sous tension/hors tension en sortie, en fonction du signal d'activation (EN), une phase d'évaluation étant plus longue que la moitié de la durée de période du signal d'horloge (CLK).

3. Convertisseur parallèle/ série selon l'une quelconque des revendications 1 ou 2, dans lequel, des transistors (M6 ... M8) prévus dans le dispositif d'évaluation (BW) entre la ligne binaire (BL) et le potentiel de masse (GND) et la ligne binaire et la tension d'alimentation (VDD) sont commandés de telle sorte qu'ils fonctionnent dans la plage à forte inversion et qu'un courant transversal permanent passe par ces transistors.

4. Convertisseur parallèle/ série selon l'une quelconque des revendications 1 à 3, dans lequel la ligne de bus (BL), à l'aide d'un générateur de niveau (PG), est maintenue à un potentiel correspondant approximativement à la tension d'alimentation (VDD), diminué de la tension de seuil (Vtp) d'un transistor à canal p et diminué de la tension de seuil (Vtn) d'un transistor à canal n.

5. Convertisseur parallèle/ série selon l'une quelconque des revendications 1 à 4, dans lequel l'unité d'évaluation (BW) et l'unité d'évaluation de référence (RBW) présentent un transistor supplémentaire (M11) entre la grille d'un transistor MOS à canal n relié à la tension d'alimentation et la tension d'alimentation, le transistor étant commandé par le signal d'activation (EN).

6. Convertisseur parallèle/ série selon l'une quelconque des revendications 1 ou 5, dans lequel le temps de propagation de signal de la ligne de bus de référence (RBL) est supérieur au temps de propagation de signal de la ligne de bus de signal (BL) par le fait que la longueur de la ligne de bus de référence est supérieure à la longueur de la ligne de bus de signal et/ou par le fait qu'en plus de la ligne de bus de référence, deux lignes sont prévues en outre qui sont parcourues par le potentiel de masse et provoquent une capacité de conduction supplémentaire.

7. Convertisseur parallèle/ série selon l'une quelconque des revendications précédentes, dans lequel un étage de retard (DBUF) est en outre connecté en aval de l'unité d'évaluation de référence.
